# EUROPÄISCHE PATENTSCHRIFT

(11) **EP 2 656 364 B1**
(45) Veröffentlichungstag und Bekanntmachung des Hinweises auf die Patenterteilung: **22.06.2016**
(21) Anmeldenummer: 11788057.5
(22) Anmeldetag: 24.11.2011
(51) Int. Cl.: B60Q 1/14, F16H 59/70, F16H 59/68, F16H 61/24, H03K 17/97

(54) **SCHALTVORRICHTUNG MIT SCHALTZUSTANDSERKENNUNG**
SWITCHING DEVICE WITH RECOGNITION OF THE SWITCHING STATE
DISPOSITIF DE COMMUTATION AVEC RECONNAISSANCE D'ÉTATS DE COMMUTATION

(30) Priorität: 23.12.2010 DE 102010064007
(43) Veröffentlichungstag der Anmeldung: 30.10.2013
(73) Patentinhaber: Bayerische Motoren Werke Aktiengesellschaft, 80809 München (DE)
(72) Erfinder: TILLE, Thomas, 81249 München (DE)
(86) Internationale Anmeldenummer: PCT/EP2011/005907
(87) Internationale Veröffentlichungsnummer: WO 2012/084113

(56) Entgegenhaltungen:
- EP-A1- 0 990 821
- EP-A1- 1 752 688
- EP-A2- 1 548 408
- DE-A1- 19 753 777
- DE-U1- 29 812 227
- US-A1- 2006 028 308

## Beschreibung

Die Erfindung betrifft eine Schaltkulisse für eine Schaltvorrichtung mit einer Schaltzustandserkennung und eine entsprechende Schaltvorrichtung, wobei die Schaltvorrichtung ein bewegbares Schaltelement, eine Schaltkulisse zum Führen des Schaltelements und ein Positionserkennungselement zum Erkennen einer Stellung des Schaltelements relativ zu der Schaltkulisse umfasst.

Derartige Schaltvorrichtungen dienen zur Eingabe bzw. Erzeugung von Signalen und Daten für ein elektronisches Gerät durch einen Benutzer. Beispielsweise kommen solche Schaltvorrichtungen zur Bedienung eines Blinkers, eines Fahrzeuglichts, der Scheibenwischer, eines Tempomats oder als elektronischer Gangwahlschalter in Getrieben mit elektronischer Gangwahl, sogenannten "Shift by Wire"- Systemen, zum Einsatz.

Aus der DE 197 58 288 B4 ist ein Verfahren und eine Vorrichtung zur drehrichtungsgekoppelten Rückstellung eines mit einem drehbaren Stellglied zusammenwirkenden Schalters bekannt, insbesondere eines mit einer Lenksäule zusammenwirkenden Blinkerhebels in einem Kraftfahrzeug, bei dem der Blinkerhebel um eine Drehachse aus der Grundstellung in eine Betriebsstellung geschwenkt wird und dabei mit einem Ende entlang einer Kulisse gleitet sowie an einer über die Kulissenkontur hervorstehenden Rastung durch diese in der Betriebsstellung gehalten wird.

Bekannt ist außerdem aus der DE 10 2006 028 228 A1 eine als Stellglied ausgebildete Schaltvorrichtung. Das Stellglied umfasst eine bewegbare Handhabe und ein Verschwenkmittel. Beide Elemente wirken derart zusammen, dass die Handhabe in einer Verschwenkebene in wenigstens eine Richtung aus einer neutralen Stellung in eine Schwenkstellung verschwenkbar ist. Hierbei ist eine Schwenkstellung des Stellglieds als Schaltstellung ausgebildet, derart, dass das Betätigungsorgan in der Schaltstellung auf ein Schaltelement, Sensorelement, Signalelement oder dergleichen zur Erzeugung eines Schaltsignals betätigend einwirkt. Das Sensorelement besteht aus einer magnetisierten Codeplatte sowie wenigstens einem zugeordneten Hallsensor, der sich auf einer Leiterplatte befindet. Die Codeplatte ist derart an dem Stellglied angelenkt, dass die Kipp- bzw. Verschwenkbewegung des Betätigungsorgans in eine Linearbewegung der Codeplatte in Bezug auf den Hallsensor umgewandelt wird. Die lineare Bewegung der Codeplatte aufgrund der manuellen Bewegung der Handhabe wird dann durch die Hall-Sensoren erfasst.

Üblicherweise erfolgt eine Positionserkennung eines Schaltzustandes der Schaltvorrichtung, also der Stellung der beschriebenen Handhabe gegenüber einer Schaltkulisse, somit über einen auf einer Platine angeordneten Hallsensor. In der Regel wird hierzu eine Mehrzahl von Hallsensoren als Hallsensorarray zum Erfassen einer Bewegung der Codeplatte vorgesehen und die Codeplatte als Permanentmagnet-Plättchen ausgeführt. Abhängig von der Stellung der Handhabe (im Folgenden als Schaltelement bezeichnet) relativ zu der Schaltkulisse, wird über eine Umlenkeinheit der Permanentmagnet über dem Hallsensorarray bewegt, so dass eindeutig der Schaltzustand bzw. die Position des Schaltelements erfasst und zugeordnet werden kann. Soll eine mehrdimensionale Bewegung des Schaltelements erfassbar sein, so wird ein weiteres Hallsensorarray mit einem weiteren Permanentmagneten zur Erfassung einer weiteren Bewegungsebene vorgesehen.

Insbesondere die beschriebene verschiebbare Anordnung der Permanentmagneten bezüglich der Hallsensorarrays erfordert einen großen Bauraumbedarf, da diese in der Regel auf einer gemeinsamen Platine angeordnet werden und dies daher ausreichend zu dimensionieren ist, um den erforderlichen Bewegungsumfang der Permanentmagneten bereitzustellen und eine zuverlässige Bewegungserkennung zu gewährleisten. Des Weiteren sehen die bekannten Systeme eine große Anzahl von Bauteilen vor. Insbesondere die große Anzahl an Hallsensoren der Hallsensorarrays sowie die Anzahl der beweglich zu lagernden Bauteile bewirken sowohl eine hohe Komplexität der Schaltung und einer nachgeschalteten Signalauswertung als auch einen entsprechenden Montageaufwand, so dass sich hieraus negative Auswirkungen auf die Kosten ergeben.

Des Weiteren ist aus der DE 298 12 227 U1 eine Vorrichtung zum Erfassen von Schalterstellungen eines mechanisch betätigbaren Schalters bekannt. Dieser umfasst ein zwangsgeführtes Schaltorgan sowie einen dem Schaltorgan zugeordneten Signalgeber. In jeder zu erfassenden Schalterstellung ist jeweils eine Aufnahmeeinheit zur Erfassung von Signalen des Signalgebers angeordnet.

Es ist daher Aufgabe der Erfindung eine Schaltvorrichtung zur Verfügung zu stellen, welche die genannten Nachteile vermeidet oder zumindest reduziert.

Gelöst wird diese Aufgabe durch eine Schaltkulisse für eine Schaltvorrichtung gemäß dem Gegenstand des Anspruchs 1 sowie durch eine Schaltvorrichtung gemäß dem Gegenstand des Anspruchs 7. Vorteilhafte Ausgestaltungen ergeben sich aus den Unteransprüchen.

Demnach wird eine Schaltkulisse für eine Schaltvorrichtung vorgeschlagen, mit einem Kulissenkörper und einer Kulissenoberfläche des Kulissenkörpers zum Abtasten mittels eines relativ hierzu bewegbaren Schaltelements der Schaltvorrichtung. Die Schaltkulisse umfasst mindestens ein Magnetelement, welches derart angeordnet ist, um in mindestens einem definierten Bereich der Kulissenoberfläche ein Magnetfeld bereitzustellen.

Die beschriebene Schaltkulisse weist also zumindest in dem mindestens einen Bereich der Kulissenoberfläche ein Magnetfeld auf. Dieses kann, wie nachfolgend noch näher beschrieben wird, von einem entsprechenden Sensor erfasst und anschließend ausgewertet werden. Die Kulissenoberfläche kann zum Führen des Schaltelements entsprechend ausgebildet sein und eine definierte Kontur aufweisen, so dass das Schaltelement beim Abtasten entlang der Kulissenoberfläche zwischen den genannten Stellungen gleitend geführt ist. Beispielsweise können auf der Kulissenoberfläche Vertiefungen vorgesehen sein, in welche das Schaltelements zumindest abschnittsweise eingreift und anhand dieser in seiner Bewegung geführt wird. Die Vertiefungen sind beispielsweise rinnenförmig bzw. nutförmig ausgebildet, so dass dem Benutzer bei dem geführten Bewegen des Schaltelements in den Vertiefungen eine haptische Wahrnehmung in Reaktion auf die Bewegung gegeben wird. Vorzugsweise kann ein Boden der Vertiefungen zu deren Enden rampenförmig ausgestaltet sein, so dass sich eine Tiefe der Vertiefungen an den entsprechenden Enden verringert. Anders ausgedrückt nimmt eine Tiefe der Rinne bzw. der Nut zu deren Enden hin ab.

Als Magnetelemente können sowohl Elemente aus magnetischen Materialien, beispielsweise Permanentmagneten oder magnetisierbaren Materialien, als auch stromdurchflossene Elemente, beispielsweise stromdurchflossene Spulen, zum Bereitstellen eines Magnetfeldes vorgesehen sein. Diese sind an oder in dem Kulissenkörper derart anzuordnen, dass in den definierten Bereichen der Kulissenoberfläche ein Magnetfeld bereitgestellt wird und dort für einen entsprechenden Sensor erfassbar ist.

Gemäß einer Ausführungsform umfasst die Schaltkulisse eine Mehrzahl von Magnetelementen, um in einer.Anzahl von definierten Bereichen jeweils mindestens ein Magnetfeld bereitzustellen, wobei jedes Magnetfeld in dem jeweils einen definierten Bereich der Kulissenoberfläche eine individuelle Magnetfeldstärke aufweist. Dies ermöglicht aufgrund der individuellen Magnetfeldstärke eine eindeutige Codierung und somit eine exakte Identifizierung des zugehörigen definierten Bereichs, in welchem das Magnetfeld mit der entsprechenden Feldstärke vorliegt. Sind also die individuellen Magnetfeldstärken sowie deren Zuordnung zu den definierten Bereichen bekannt, so kann exakt bestimmt werden, welches Magnetfeld bzw. welchen Bereich der Sensor momentan erfasst.

Entsprechend einer weiteren Ausführungsform besteht der Kulissenkörper der Schaltkulisse mindestens teilweise aus magnetischem Material und ist als Magnetelement ausgebildet. Dies bedeutet, dass der Kulissenkörper selbst eines der mindestens einen Magnetelemente darstellt und hierzu entweder komplett oder lediglich in Teilbereichen aus magnetischem Material besteht. Alternativ kann der Kulissenkörper einstückig aus magnetischem Material ausgebildet sein. Ein teilweiser Aufbau aus magnetischem Material kann dagegen durch einen schichtweisen Aufbau aus nicht-magnetischem und magnetischem Material erzielt werden. Ebenfalls alternativ können in Teilbereichen Einsätze aus magnetischem Material in einem ansonsten aus nicht-magnetischem Material bestehenden Kulissenkörper vorgesehen werden. Der Kulissenkörper ist somit, zumindest teilweise, zur Bereitstellung von Magnetfeldern ausgebildet.

Gemäß einer Ausführungsform weist der Kulissenkörper eine inhomogene Magnetisierung zum Bereitstellen von Magnetfeldern mit individuellen Magnetfeldstärken in den definierten Bereichen der Kulissenoberfläche auf. Dies kann beispielsweise bei einer Herstellung des Kulissenkörpers durch eine partielle Magnetisierung bzw. eine partiell unterschiedliche Magnetisierung des Kulissenkörpers erzielt werden, so dass einzelne Abschnitte des Kulissenkörpers, insbesondere im Bereich der Kulissenoberfläche, einen lokal unterschiedlichen Magnetisierungsgrad aufweisen. Je nach lokalem Magnetisierungsgrad wird demensprechend ein Magnetfeld bereitgestellt, das sich in seiner Magnetfeldstärke von benachbarten Magnetfeldern unterscheidet und somit eine individuelle Magnetfeldstärke aufweist. Diese erlaubt entsprechend der voranstehenden Beschreibung eine entsprechende Zuordnung und Identifizierung des jeweils zugehörigen definierten Bereichs. Alternativ kann der Kulissenkörper der Schaltkulisse aus einem nicht-magnetischen Material bestehen und die Magnetelemente beabstandet zu der Kulissenoberfläche mit dem Kulissenkörper verbunden sein. Dies bedeutet, dass die Magnetelemente nicht unmittelbar an die Kulissenoberfläche angrenzen. Vielmehr können die Magnetelemente innerhalb des Kulissenkörpers oder angrenzend hierzu angeordnet werden, so dass das jeweils erzeugte Magnetfeld noch in ausreichendem Maße an der Kulissenoberfläche detektierbar ist und dort von dem entsprechenden Sensor ermittelt werden kann. Beispielsweise können Magnetelemente auf einer der Kulissenoberfläche abgewandten Unterseite oder auf Seitenflächen des Kulissenkörpers angeordnet sein. Ist der Kulissenkörper als Hohlkörper ausgebildet, so können die Magnetelemente auf einer der Kulissenoberfläche entgegengesetzten Rückseite einer Wandung des Kulissenkörpers angeordnet werden. Verschiedene beispielhafte Ausführungsformen sind hierzu nachfolgend in den Figuren dargestellt.

Insbesondere eine beabstandete Anordnung der Magnetelemente ermöglicht den Einsatz von baugleichen Magnetelementen mit einer gleichen Magnetfeldstärke. Hierbei kann die Schaltkulisse derart ausgestaltet sein, dass sich jeweilige Abstände der definierten Bereiche der Kulissenoberfläche zu den Magnetelementen voneinander unterscheiden, um in den definierten Bereichen Magnetfelder mit einer jeweils individuellen Magnetfeldstärke bereitzustellen. Die unterschiedliche Magnetfeldstärke in den definierten Bereichen an der Kulissenoberfläche wird also durch einen individuell unterschiedlichen Abstand des entsprechenden Bereichs zu dem Magnetelement erzielt.

Alternativ oder zusätzlich können die Magnetelemente jeweils einen individuellen Magnetisierungsgrad zum Bereitstellen von Magnetfeldern mit jeweils individuellen Magnetfeldstärken aufweisen. Im Gegensatz zu der voranstehend beschriebenen Ausführungsform werden also anstelle baugleicher Magnetelemente zur Erzeugung von Magnetfeldern mit gleicher Magnetfeldstärke Magnetelemente eingesetzt, die ein Magnetfeld mit individueller Magnetfeldstärke bereitstellen. Im Falle von stromdurchflossenen Elementen kann selbstverständlich eine gleiche Bauform vorliegen und lediglich ein jeweiliger Stromfluss variiert werden.

Des Weiteren wird eine Schaltvorrichtung zur manuellen Ansteuerung eines Signalgebers, insbesondere für ein Kraftfahrzeug bereitgestellt, mit einer Schaltkulisse und einem relativ hierzu bewegbaren Schaltelement zum Betätigen der Schaltvorrichtung, wobei das Schaltelement in der Schaltkulisse zwischen einer Neutralstellung und mindestens einer Schaltstellung bewegbar geführt ist und die Schaltkulisse die Neutralstellung und die mindestens eine Schaltstellung definiert. Außerdem umfasst die Schaltvorrichtung ein Positionserkennungselement, welches zum Erkennen einer Stellung des Schaltelements relativ zu der Schaltkulisse ausgebildet ist. Des Weiteren ist die Schaltkulisse gemäß der gegebenen Beschreibung ausgebildet, wobei die definierten Bereiche der Kulissenoberfläche der Schaltkulisse der Neutralstellung des Schaltelements und der mindestens einen Schaltstellung des Schaltelements zugeordnet sind. Außerdem ist das Positionserkennungselement für das Erkennen der jeweiligen Stellung des Schaltelements zum Bestimmen einer Magnetfeldstärke in den definierten Bereichen der Kulissenoberfläche ausgebildet.

Das Schaltelement wird also bei einer Betätigung der Schaltvorrichtung abtastend über die bzw. in der Schaltkulisse geführt. Vorzugsweise gibt die Schaltkulisse hierbei einen Bewegungsumfang bzw. eine Bewegungsrichtung zwischen der Neutralstellung und der mindestens einen Schaltstellung vor. Wie voranstehend beschrieben, kann die Schaltkulisse auf der Kulissenoberfläche Vertiefungen vorsehen, in die das Schaltelement bzw. ein Abschnitt des Schaltelements eingreift, so dass dieses somit bei einer Bewegung in vordefinierten Richtungen geführt wird.

Vorzugsweise sind der Neutralstellung des Schaltelements und der mindestens einen Schwenkstellung des Schaltelements definierte Bereiche der Schaltkulisse bzw. der Kulissenoberfläche zugeordnet. Befindet sich also das Schaltelement in der Neutralstellung, so beaufschlägt dieses reproduzierbar einen ersten definierten Bereich der Kulissenoberfläche. Befindet sich das Schaltelement in einer der mindestens einen Schaltstellung, so kann auch hierzu ein definierter Bereich der Kulissenoberfläche bestimmt werden, der in dieser Stellung von dem Schaltelement beaufschlagt wird. Es versteht sich daher von selbst, dass jeder einzelnen der mindestens einen Schaltstellung ein eigener definierter Bereich der Kulissenoberfläche zugeordnet werden muss, um eine eindeutige Identifizierung der aktuellen Stellung des Schaltelements zu gewährleisten. Selbstverständlich kann daher eine beliebige Anzahl von Schaltstellungen vorgesehen sein. Ebenso kann die Neutralstellung selbst eine Schaltstellung darstellen.

Um nun die momentane Stellung des Schaltelements bezüglich der Schaltkulisse eindeutig bestimmen zu können, sind den verschiedenen definierten Bereichen der Kulissenoberflächen jeweils individuelle Magnetfeldstärken zugeordnet. Dies bedeutet, dass jeder dieser definierten Bereiche eine andere Magnetfeldstärke aufweist. Hierbei kann die Magnetfeldstärke lediglich zwischen den der Neutralstellung und den der mindestens einen Schaltstellung zugeordneten definierten Bereichen unterschiedlich ausgebildet sein. Somit ist eine Unterscheidung lediglich dahingehend möglich, ob sich das Schaltelement in der Neutralstellung oder einer der Schaltstellungen befindet. Alternativ können mehrere definierte Bereiche zu einer Untermenge zusammengefasst und einer Anzahl von Schaltstellungen zugeordnet sein, wobei diese eine gleiche Magnetfeldstärke aufweisen, so dass eine Gruppierung mehrerer Bereiche bzw. Stellungen ohne individuelle Differenzierung möglich ist. Vorzugsweise weist jeder der definierten Bereiche eine eigene individuelle Magnetfeldstärke auf. Somit ist jeder Bereich eineindeutig codiert, so dass eine sichere Bestimmung der aktuellen Stellung des Schaltelements ermöglicht wird.

Die jeweilige Magnetfeldstärke liegt somit lediglich örtlich bzw. punktuell vor und ist somit dem entsprechenden definierten Bereich der Schaltkulisse zugeordnet. Diese wird von dem Positionserkennungselement erkannt, sobald sich das Schaltelement in der entsprechenden Stellung befindet. Es kann nun die lokale Magnetfeldstärke gemessen werden und hieraus unmittelbar im Umkehrschluss die entsprechende Stellung des Schaltelements bestimmt werden.

Vorzugsweise umfasst das Positionserkennungselement einen Magnetfeldsensor zum Bestimmen der jeweiligen lokalen Magnetfeldstärke. Vorzugsweise ist der Magnetfeldsensor derart an dem Schaltelement angeordnet, dass dieser in einem eingebauten Zustand einen möglichst geringen Abstand zu der Kulissenoberfläche aufweist. Beispielsweise kann der Magnetfeldsensor im Bereich eines ersten freien Endes eines stabförmig ausgebildeten Schaltelements angeordnet sein, wobei das freie Ende der Schaltkulisse zugewandt ist und gegebenenfalls in gleitendem Kontakt mit der Kulissenoberfläche angeordnet ist. Der Magnetfeldsensor wird somit bei einer Bewegung des Schaltelements mit dem freien Ende in unmittelbarer Nähe zu der Schaltkulisse bewegt, um die lokale Magnetfeldstärke zu messen. Als Magnetfeldsensor kann beispielsweise ein Hallsensor eingesetzt werden.

Eine Ausführungsform der Schaltvorrichtung sieht vor, dass das Schaltelement relativ zu der Schaltkulisse zwischen der Neutralstellung und der mindestens einen Schaltstellung im Wesentlichen schwenkbar oder in einer Ebene verschiebbar ausgebildet ist. Dies bedeutet, dass das Schaltelement um mindestens eine Schwenkachse schwenkbar gelagert sein kann, wobei das beschriebene freie Ende vorzugsweise beabstandet von der Drehachse angeordnet ist, um eine Schwenkbewegung beim Schwenken des Schaltelements durchzuführen. Alternativ kann das Schaltelement in einer Ebene verschiebbar ausgebildet sein. In diesem Fall erfolgt beispielsweise eine Parallelverschiebung des Schaltelements. Vorzugsweise wird das Schaltelement innerhalb einer parallel zu der Kulissenoberfläche angeordneten Ebene verschoben. Hierbei steht das freie Ende beispielsweise senkrecht zu der Kulissenoberfläche und somit zu der genannten Ebene.

Vorzugsweise umfasst das Schaltelement einen längenvariablen Stift zum Abtasten der dem Schaltelement zugewandten Kulissenoberfläche der Schaltkulisse. Das Schaltelement weist demnach einen Stift auf, der bei einer Bewegung des Schaltelements in der Schaltkulisse geführt wird und mit seinem freien Ende entlang der Kulissenoberfläche gleitet. Der vorgesehene Längenausgleich ermöglicht eine entsprechende Anpassung an den Verlauf der Kulissenoberfläche und kann somit eine entsprechende Rückmeldung an den Nutzer vermitteln. Hierdurch basiert die beschriebene Schaltvorrichtung auf einer kulissengeführten Bedienhaptik. Vorzugsweise ist das Schaltelement bolzen- bzw. stabförmig ausgebildet und umfasst den beschriebenen längenvariablen Stift an seinem der Kulissenoberfläche zugewandten freien Ende.

Die beschriebene Schaltvorrichtung ist in vielen verschiedenen technischen Bereichen einsetzbar, in welchen ein Schalter mit einem Stellglied zur Erzeugung eines Schaltsignals vorgesehen werden soll. Somit ist ein Einsatz in verschiedensten Maschinen möglich. Insbesondere im Kraftfahrzeugbereich finden derartige Haptik-gebende Schaltvorrichtungen Anwendung. Beispielsweise kann die beschriebene Schaltvorrichtung ein Bedienhebel, insbesondere ein Lenkstockschalter, ein elektrischer Gangwahlschalter, ein Blinkerschalter, ein Wischerschalter oder ein Tempomatschalter, sein. Ebenso kann die Schaltvorrichtung auch als ein anderweitiger Bedienhebel zur Steuerung weiterer Funktionen vorgesehen sein. Die gegebene Aufzählung ist daher im Hinblick auf die voranstehende Darstellung lediglich beispielhaft und keinesfalls abschließend zu verstehen.

Die beschriebene Schaltvorrichtung basiert somit auf einer Positionserkennung, die durch das Haptik-gebende Element der Schaltkulisse ermöglicht wird. Auf diese Weise wird eine deutliche Miniaturisierung der Sensorauswerteeinheit erreicht, wodurch sich Bauraum-Vorteile für die gesamte Schaltvorrichtung sowie eine Qualitätsverbesserung aufgrund einer geringeren Komplexität und eine hiermit verbundene Kostenreduktion erzielen lassen.

Die Erfindung wird nachfolgend unter Bezugnahme auf die beigefügte Zeichnung näher erläutert. Dabei zeigen:
- Figur 1: eine schematische seitliche Schnittansicht einer ersten Ausführungsform einer erfindungsgemäßen Schaltvorrichtung,
- Figur 2: eine Darstellung einer Relativbewegung eines Schaltelements relativ zu einer Schaltkulisse in schematischer, seitlicher Schnittansicht in mehreren Schritten,
- Figur 3: eine beispielhafte Schaltungsanordnung zur Auswertung einer Positionserkennung der erfindungsgemäßen Schaltvorrichtung,
- Figur 4: einen beispielhaften Ausgangsspannungsverlauf in Abhängigkeit von einer Schaltposition für die in Fig. 2 dargestellte Relativbewegung,
- Figur 5: eine Darstellung einer Relativbewegung eines Schaltelements relativ zu einer Schaltkulisse in schematischer seitlicher Schnittansicht für eine zweite Ausführungsform einer erfindungsgemäßen Schaltvorrichtung und
- Fig. 6 und Fig. 7: weitere beispielhafte Ausgestaltungsformen einer erfindungsgemäßen Schaltkulisse in schematischer Darstellung.

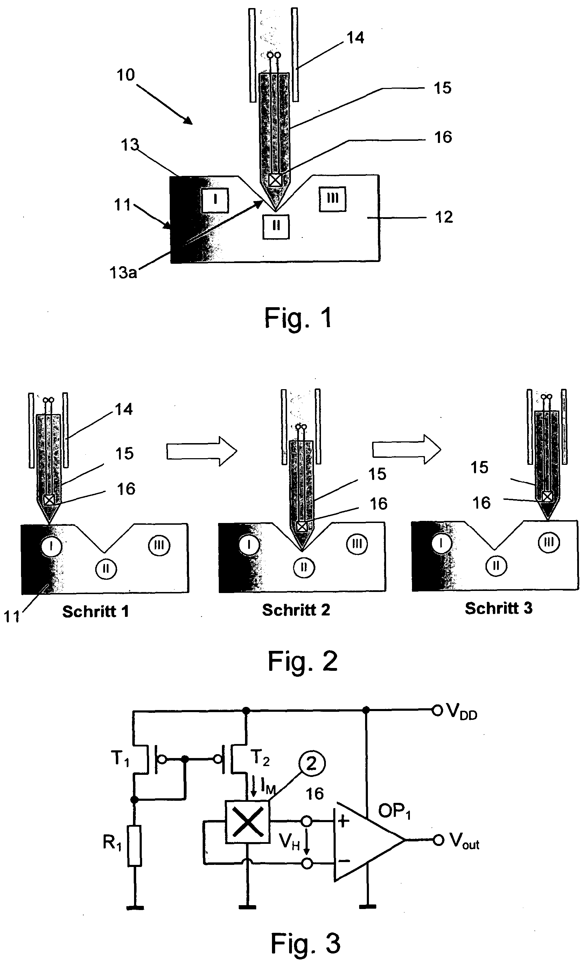

Fig. 1 zeigt in schematischer Darstellung eine geschnittene Seitenansicht einer ersten Ausführungsform einer erfindungsgemäßen Schaltvorrichtung 10. Diese umfasst eine Schaltkulisse 11 mit einem Kulissenkörper 12, der eine Kulissenoberfläche 13 aufweist. Die Kulissenoberfläche 13 umfasst eine Vertiefung 13a, in welcher ein relativ zu der Schaltkulisse 11 bewegbares Schaltelement 14 eingreift. Das Schaltelement 14 ist stabförmig ausgebildet und weist einen Längenausgleich sowie ein freies Ende 15 auf, in welchem ein Magnetfeldsensor 16 zum Erkennen einer Stellung des Schaltelements 14 relativ zu der Schaltkulisse 11 angeordnet ist. Des Weiteren umfasst die Schaltkulisse 11 ein Magnetelement bzw. ist als solches ausgebildet. Hierzu kann der Kulissenkörper 12 beispielsweise aus magnetischem Material gebildet sein, welches inhomogen magnetisiert ist. Dies bedeutet, dass der Kulissenkörper 12 in unterschiedlichen Teilabschnitten einen unterschiedlichen Magnetisierungsgrad aufweist. Dies ist in der dargestellten Ausführungsform anhand einer von links nach rechts abnehmenden Schattierung symbolisiert, welche eine lokale Magnetfeldstärke darstellen soll. Aufgrund der unterschiedlichen Magnetisierungsgrade, ist auch eine Magnetfeldstärkeverteilung im Bereich der Kulissenoberfläche 13 inhomogen. In einem Bereich I liegt ein hoher Magnetisierungsgrad und folglich eine große Magnetfeldstärke vor. Diese nimmt in den Bereichen II und III kontinuierlich ab.

Im Gegensatz zu bekannten Schaltvorrichtungen mit mehreren Hallsensorarrays mit mechanischen Verschiebevorrichtungen für Permanentmagneten und Umlenkeinheiten nutzt die dargestellte Schaltvorrichtung 10 die Schaltkulisse 11 als Haptik-gebendes Element und das stabförmige Schaltelement 14 bzw. den Schaltbolzen als intelligente Haptik-Konstruktion mit integrierter Positionssensorik. Aufgrund der unterschiedlichen Magnetisierungsgrade und den daraus resultierenden unterschiedlichen Magnetfeldstärken in den Bereichen I, II und III der Kulissenoberfläche 13 kann eine eindeutige Erkennung der momentanen Stellung des Schaltelements 14 bezüglich der Schaltkulisse 11 ermittelt werden, indem der an dem freien Ende 15 des Schaltelements 14 angeordnete Magnetfeldsensor 16 eine Magnetfeldstärke ermittelt und auswertet.

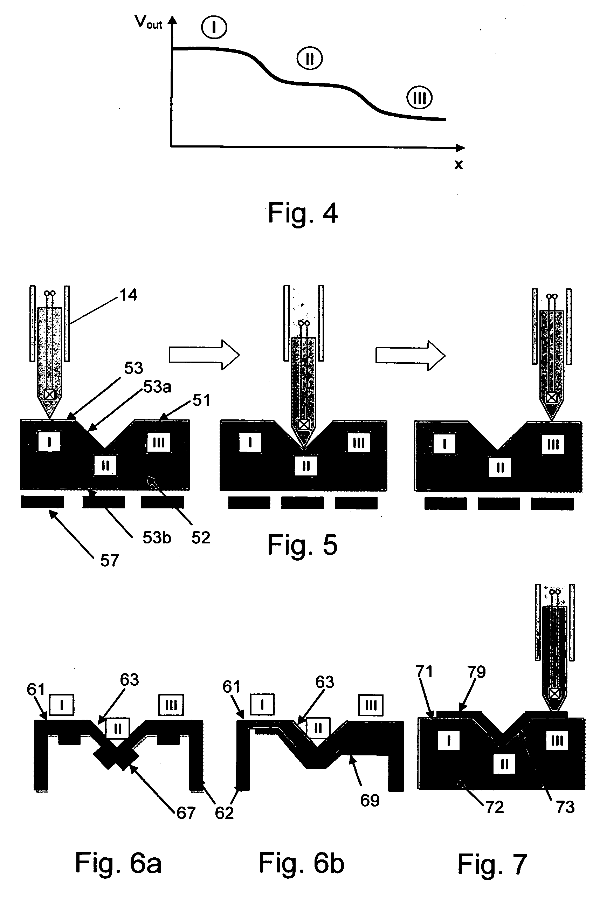

Fig. 2 zeigt eine Darstellung einer Relativbewegung eines Schaltelements 14 der in Fig. 1 beschriebenen Schaltvorrichtung 10 relativ zu der Schaltkulisse 11 bzw. dem Kulissenkörper 12 in schematischer Seitenansicht. Befindet sich das Schaltelement 14 in einer ersten Schaltstellung, in der das freie Ende 15 den definierten Bereich I der Kulissenoberfläche 13 kontaktiert, so wird am Magnetfelddetektor 16 ein Magnetfeld mit einer ersten Magnetfeldstärke gemessen und ein hiervon abhängiges Ausgangssignal erzeugt. Wird das Schaltelement 14 in einem zweiten Schritt seitlich bewegt, so dass das freie Ende 15 den definierten Bereich II kontaktiert, so ändert sich aufgrund des abnehmenden Magnetisierungsgrades der Schaltkulisse 11 die lokal gemessene Magnetfeldstärke auf einen geringeren Wert. Demensprechend verändert sich auch das Ausgangssignal des Magnetfelddetektors 16. Eine weitere Veränderung tritt entsprechend bei einer weiteren Bewegung in Richtung des definierten Bereichs III auf. Ein beispielhafter Verlauf eines Ausgangssignals des Magnetfelddetektors 16 ist in der nachfolgenden Figur 4 dargestellt.

Fig. 3 stellt eine beispielhafte Schaltungsanordnung zur Auswertung einer Positionserkennung der erfindungsgemäßen Schaltvorrichtung 10 anhand eines Ausgangssignals des Magnetfelddetektors 16 dar. Hierbei wird der Magnetfelddetektor 16 über einen konstanten Strom I_{M} aus einer Stromspiegelschaltung (T₁, T₂, R₁) versorgt. Das Ausgangssignal V_{H} des Magnetfelddetektors 16 wird über einen Operationsverstärker OP₁ verstärkt und als Signal Vₒᵤₜ zu einer weiteren Signalverarbeitung aufgegeben. Fig.4 beschreibt einen beispielhaften Ausgangsspannungsverlauf der Schaltungsanordnung nach Fig. 3 in Abhängigkeit von einer Schaltstellung für die in Fig. 2 dargestellte Relativbewegung des Schaltelements 14. Die von dem Magnetfeldsensor 16 ausgegebene Ausgangsspannung gibt hierbei eine Höhe einer Magnetfeldstärke an den definierten Bereichen I, II, III sowie zwischen diesen wieder. Sind die Spannungswerte bzw. die zugehörigen Werte der Magnetfeldstärke bekannt, so kann anhand eines beliebigen Wertes einer Ausgangsspannung direkt der zugehörige definierte Bereich und somit die Stellung des Schaltelements 14 ermittelt werden.

Fig. 5 zeigt eine Darstellung einer Relativbewegung eines Schaltelements 14 relativ zu einer Schaltkulisse 51 in schematischer Seitenansicht für eine zweite Ausführungsform einer erfindungsgemäßen Schaltvorrichtung 50. Diese umfasst ebenfalls eine Schaltkulisse 51 mit einem Kulissenkörper 52 und einer Kulissenoberfläche 53 sowie einer Vertiefung 53a. Dementsprechend kann weitestgehend auf die voranstehende Beschreibung verwiesen werden. Im Gegensatz dazu ist jedoch der Kulissenkörper 52 nicht aus einem magnetischen Material sondern aus einem nicht-magnetischen Material gebildet. Der Kulissenkörper 52 weist jedoch auf einer der Kulissenoberfläche 53 entgegengesetzt angeordneten Unterseite 53b drei zusätzliche Magnetelemente 57 auf. Diese stellen jeweils ein Magnetfeld bereit, das sich jeweils durch den Kulissenkörper 52 erstreckt und insbesondere in den definierten Bereichen I, II, III von dem Magnetfeldsensor 16 detektierbar ist. Diese Anordnung erlaubt eine vergleichsweise kostengünstige Herstellung, da die Magnetelemente 57 lediglich auf der Unterseite des Kulissenkörpers 52 angeordnet werden. Weisen die Magnetelemente 57 jeweils einen gleichen Magnetisierungsgrad auf, so dass sie ein jeweils gleichstarkes Magnetfeld bereitstellen, so wird in der dargestellten Ausführungsform in den definierten Bereichen I und III derselbe Messwert bestimmt, wohingegen aufgrund des geringeren Abstandes des definierten Bereichs II von dem bzw. den Magnetelementen 57 ein stärkerer Messwert ermittelt wird. Somit kann bereits eine Unterscheidung zwischen den Bereichen I und III zugeordneten Stellungen des Schaltelements und der dem Bereich II zugeordneten Stellung erfolgen. Soll dagegen in jedem Bereich I, II, III eine eindeutige Erkennung möglich sein, so ist beilspielsweise die Stärke des von den jeweiligen Magnetelementen bereitgestellten Magnetfelds unterschiedlich auszulegen. Alternativ oder zusätzlich kann ein Abstand des jeweiligen definierten Bereichs I, II, III zu dem entsprechenden Magnetelement 57 verändert werden.

Fig. 6a, 6b und Fig. 7 zeigen weitere beispielhafte Ausgestaltungsformen einer erfindungsgemäßen Schaltkulisse in schematischer Darstellung. In Fig. 6a ist eine Schaltkulisse 61 für eine der voranstehend beschriebenen Schaltvorrichtungen dargestellt, die als Hohlkörper ausgestaltet ist, wie er beispielsweise mittels eines Spritzgussverfahrens hergestellt werden kann. Die Schaltkulisse 61 umfasst einen Kulissenkörper 62, der als dünnwandiger Körper mit einer Kulissenoberfläche 63 ausgeführt ist. Auf einer der Kulissenoberfläche 63 entgegengesetzt angeordneten Unterseite sind separate Magnetelemente 67 nahe der definierten Bereiche I, II, III angeordnet, um in den definierten Bereichen I, II, III der Kulissenoberfläche 63 jeweils ein Magnetfeld bereitzustellen.

Alternativ kann, wie in Fig. 6b dargestellt, die als Hohlkörper ausgebildete Schaltkulisse 61 einen Kulissenkörper 62 aufweisen, der eine lokal unterschiedliche Bodendicke bzw. eine unterschiedliche Dicke der Wandung seines dünnwandigen Körpers aufweist. Die jeweilige lokale Dicke ist in der dargestellten Ausführungsform für den definierten Bereich III größer als die des definierten Bereichs II und diese wiederum größer als die lokale Dicke für den definierten Bereich I. Somit liegt zwischen einer Magnetschicht 69, die auf einer Unterseite des Kulissenkörpers 62 aufgebracht ist und den Bereichen I, II und III auf der Kulissenoberfläche 63 jeweils ein unterschiedlicher Abstand vor, so dass eine jeweilige Magnetfeldstärke in den definierten Bereichen I, II, III unterschiedlich hoch ist. Die Magnetschicht 69 kann somit eine homogene Dicke aufweisen sowie homogen magnetisiert sein und beispielsweise aufgedampft werden. Als Beschichtungsverfahren eignet sich hierzu beispielsweise das PVD-Verfahren. Alternativ können ebenso Magnetelemente 67 an den entsprechenden Stellen angeordnet sein. Fig. 7 zeigt eine Schaltkulisse 71 mit einem Kulissenkörper 72 und einer Kulissenoberfläche 73, wobei auf der Kulissenoberfläche 73 eine Schicht 79 mit Magnetelementen, beispielsweise eine Magnetbeschichtung, aufgebracht ist. Hierbei kann die Schicht inhomogen magnetisch sein, um in den definierten Bereichen I, II, III individuelle Magnetfeldstärken bereitzustellen und/oder eine ungleichförmige Geometrie für den gleichen Zweck aufweisen.

### Bezugszeichenliste

- 10: Schaltvorrichtung
- 11: Schaltkulisse
- 12: Kulissenkörper
- 13: Kulissenoberfläche
- 13a: Vertiefung
- 14: Schaltelement
- 15: freies Ende
- 16: Magnetfeldsensor

- 51: Schaltkulisse
- 52: Kulissenkörper
- 53: Kulissenoberfläche
- 53a: Vertiefung
- 53b: Unterseite
- 57: Magnetelemente

- 61: Schaltkulisse
- 62: Kulissenkörper
- 63: Kulissenoberfläche
- 67: Magnetelemente
- 69: Magnetschicht

- 71: Schaltkulisse
- 72: Kulissenkörper
- 73: Kulissenoberfläche
- 79: Magnetschicht

## Patentansprüche

1. Schaltkulisse für eine Schaltvorrichtung, mit
- einem Kulissenkörper (12) und
- einer Kulissenoberfläche (13) des Kulissenkörpers (12) zum Abtasten mittels eines relativ hierzu bewegbaren Schaltelements (14) der Schaltvorrichtung,
**dadurch gekennzeichnet, dass**
die Schaltkulisse (11) eine Mehrzahl von Magnetelementen (57) umfasst, welche derart angeordnet sind, um in einer Anzahl von definierten Bereichen (I, II, III) der Kulissenführung (13) jeweils mindestens ein Magnetfeld bereitzustellen, wobei jedes Magnetfeld in dem jeweils einen definierten Bereich (I, II, III) der Kulissenoberfläche (13) eine individuelle Magnetfeldstärke aufweist.

2. Schaltkulisse nach Anspruch 1, **dadurch gekennzeichnet, dass** der Kulissenkörper (12) der Schaltkulisse (11) mindestens teilweise aus magnetischem Material besteht und als Magnetelement ausgebildet ist.

3. Schaltkulisse nach Anspruch 2, **dadurch gekennzeichnet, dass** der Kulissenkörper (13) eine inhomogene Magnetisierung zum Bereitstellen von individuellen Magnetfeldstärken in den definierten Bereichen (I, II, III) der Kulissenoberfläche (13) aufweist.

4. Schaltkulisse nach Anspruch 1, **dadurch gekennzeichnet, dass** der Kulissenkörper (12) der Schaltkulisse (11) aus einem nicht magnetischen Material besteht und die Magnetelemente (57) beabstandet zu der Kulissenoberfläche (13) mit dem Kulissenkörper (12) verbunden sind.

5. Schaltkulisse nach Anspruch 4, **dadurch gekennzeichnet, dass** sich jeweilige Abstände der definierten Bereiche (I, II, III) der Kulissenoberfläche (13) zu den Magnetelementen (57) voneinander unterscheiden, um in den definierten Bereichen (I, II, III) Magnetfelder mit einer jeweils individuellen Magnetfeldstärke bereitzustellen.

6. Schaltkulisse nach Anspruch 4, **dadurch gekennzeichnet, dass** die Magnetelemente (57) jeweils einen individuellen Magnetisierungsgrad zum Bereitstellen von Magnetfeldern mit jeweils individuellen Magnetfeldstärken aufweisen.

7. Schaltvorrichtung zum manuellen Ansteuern eines Signalgebers, insbesondere für ein Kraftfahrzeug, mit
- einer Schaltkulisse (11),
- einem relativ hierzu bewegbaren Schaltelement (14) zum Betätigen der Schaltvorrichtung (10), wobei das Schaltelement (14) in der Schaltkulisse (11) zwischen einer Neutralstellung und mindestens einer Schaltstellung bewegbar geführt ist und die Schaltkulisse (11) die Neutralstellung und die mindestens eine Schaltstellung definiert, und
- einem Positionserkennungselement (16), welches zum Erkennen einer Stellung des Schaltelements (14) relativ zu der Schaltkulisse (11) ausgebildet ist,
**dadurch gekennzeichnet, dass**
die Schaltkulisse (11) nach einem der Ansprüche 1 bis 6 ausgebildet ist, wobei die definierten Bereiche (I, II, III) der Kulissenoberfläche (13) der Schaltkulisse (11) der Neutralstellung des Schaltelements (14) und der mindestens einen Schaltstellung des Schaltelements (14) zugeordnet sind, und das Positionserkennungselement (16) für ein Erkennen der jeweiligen Stellung des Schaltelements (14) zum Bestimmen einer Magnetfeldstärke in den definierten Bereichen (I, II, III) der Kulissenoberfläche (13) ausgebildet ist.

8. Schaltvorrichtung nach Anspruch 7, **dadurch gekennzeichnet, dass** das Positionserkennungselement (16) einen Magnetfeldsensor zum Bestimmen der jeweiligen Magnetfeldstärke umfasst.

9. Schaltvorrichtung nach einem der Ansprüche 7 bis 8, wobei das Schaltelement (14) relativ zu der Schaltkulisse (11) zwischen der Neutralstellung und der mindestens einen Schaltstellung im Wesentlichen schwenkbar oder in einer Ebene verschiebbar ausgebildet ist.

10. Schaltvorrichtung nach einem der Ansprüche 7 bis 9, **dadurch gekennzeichnet, dass** das Schaltelement (14) einen längenvariablen Stift zum Abtasten der dem Schaltelement (14) zugewandten Kulissenoberfläche (13) der Schaltkulisse (11) umfasst.

11. Schaltvorrichtung nach einem der Ansprüche 7 bis 10, **dadurch gekennzeichnet, dass** die Schaltvorrichtung (10) ein Bedienhebel, insbesondere ein Lenkstockschalter, ein elektrischer Gangwahlschalter, ein Blinkerhebel, ein Wischerschalter oder ein Tempomatschalter, ist.

## Claims

1. A switch guide plate for a switching device, comprising
- a guide plate body (12) and
- a guide plate surface (13) of the guide plate body (12) to be probed by means of a switching element (14), movable relative thereto, of the switching device,
**characterised in that**
the switch guide plate (11) comprises a plurality of magnetic elements (57) which are arranged in such a way to provide in each case at least one magnetic field in a number of defined regions (I, II, III) of the guide plate guidance (13), each magnetic field in the one defined region (I, II, III) in each case of the guide plate surface (13) having an individual magnetic field strength.

2. A switch guide plate according to claim 1, **characterised in that** the guide plate body (12) of the switch guide plate (11) at least partly comprises magnetic material and is configured as a magnetic element.

3. A switch guide plate according to claim 2, **characterised in that** the guide plate body (13) has an inhomogeneous magnetisation for providing individual magnetic field strengths in the defined regions (I, II, III) of the guide plate surface (13).

4. A switch guide plate according to claim 1, **characterised in that** the guide plate body (12) of the switch guide plate (11) comprises a non-magnetic material and the magnetic elements (57) are connected to the guide plate body (12) at a distance from the guide plate surface (13).

5. A switch guide plate according to claim 4, **characterised in that** respective distances of the defined regions (I, II, III) of the guide plate surface (13) from the magnetic elements (57) differ from one another in order to provide magnetic fields with a respectively individual magnetic field strength in the defined regions (I, II, III).

6. A switch guide plate according to claim 4, **characterised in that** the magnetic elements (57) have a respective individual degree of magnetisation to provide magnetic fields having respectively individual magnetic field strengths.

7. A switching device for manually controlling a signal transmitter, especially for a motor vehicle, comprising
- a switch guide plate (11),
- a switching element (14), movable relative thereto, for actuating the switching device (10), the switching element (14) being movably guided in the switch guide plate (11) between a neutral position and at least one switching position, and the switch guide plate (11) defining the neutral position and the at least one switching position, and
- a position detecting element (16) which is configured to detect a position of the switching element (14) relative to the switch guide plate (11),
**characterised in that**
the switch guide plate (11) is configured according to any one of claims 1 to 6, the defined regions (I, II, III) of the guide plate surface (13) of the switch guide plate (11) being associated with the neutral position of the switching element (14) and the at least one switching position of the switching element (14), and the position detecting element (16) is configured to detect the respective position of the switching element (14) to determine a magnetic field strength in the defined regions (I, II, III) of the guide plate surface (13).

8. A switch device according to claim 7, **characterised in that** the position detecting element (16) comprises a magnetic field sensor for determining the respective magnetic field strength.

9. A switch device according to either of claims 7 to 8, wherein the switching element (14) is configured to be substantially swivellable or displaceable in one plane relative to the switch guide plate (11) between the neutral position and the at least one switching position.

10. A switch device according to any one of claims 7 to 9, **characterised in that** the switching element (14) comprises a pin with a variable length for probing the guide plate surface (13), facing the switching element (14), of the switch guide plate (11).

11. A switch device according to any one of claims 7 to 10, **characterised in that** the switching device (10) is a control lever, especially a steering column switch, an electrical gear selector switch, a direction indicator control, a wiper switch or a cruise control switch.

## Revendications

1. Coulisse de commutation destinée à un dispositif de commutation comprenant :
- un corps de coulisse (12), et
- une surface de coulisse (13) du corps de coulisse (12) pour permettre d'effectuer une palpation au moyen d'un élément de commutation (14) du dispositif de commutation mobile par rapport à celle-ci,
**caractérisée en ce que**
la coulisse de commutation (11) comprend un ensemble d'éléments magnétiques (57) qui sont montés de sorte que dans un nombre de zones définies (I, II, II) du guidage de coulisse (13) il y ait respectivement au moins un champ magnétique, chacun de ces champs magnétiques ayant une intensité de champ magnétique individuelle dans une zone définie respective (I, II, III) de la surface de coulisse (13).

2. Coulisse de commutation conforme à la revendication 1, **caractérisée en ce que**
le corps de coulisse (12) de la coulisse de commutation (11) est constitué au moins partiellement d'un matériau magnétique et est réalisé sous la forme d'un élément magnétique.

3. Coulisse de commutation conforme à la revendication 2, **caractérisée en ce que**
le corps de coulisse (12) a une aimantation non homogène pour permettre d'obtenir des intensités de champ magnétique individuelle dans les zones définies (I, II, III) de la surface de coulisse (13).

4. Coulisse de commutation conforme à la revendication 1, **caractérisée en ce que**
le corps de coulisse (12) de la coulisse de commutation (11) est en un matériau non magnétique et les éléments magnétiques (57) sont reliés au corps de coulisse (12) en étant situés à distance de la surface de coulisse (13).

5. Coulisse de commutation conforme à la revendication 4, **caractérisée en ce que**
les distances respectives des zones définies (I, II, III) de la surface de coulisse (13) aux éléments magnétiques (57) diffèrent les unes des autres pour pouvoir obtenir dans les zones définies (I, II, III) des champs magnétiques ayant respectivement une intensité de champ magnétique individuelle.

6. Coulisse de commutation conforme à la revendication 4, **caractérisée en ce que**
les éléments magnétiques (57) ont respectivement un degré d'aimantation individuel pour pouvoir obtenir des champs magnétiques ayant respectivement des intensités de champ magnétique individuelles.

7. Dispositif de commutation destiné à permettre la commande manuelle d'un émetteur de signal, en particulier dans un véhicule automobile comprenant :
- une coulisse de commutation (11),
- un élément de commutation (14) mobile par rapport à celle-ci pour permettre d'actionner le dispositif de commutation (10), l'élément de commutation (14) pouvant être déplacé dans la coulisse de commutation (11) entre une position neutre et au moins une position de commutation, et la coulisse de commutation (11) définissant la position neutre et la ou les position(s) de commutation, et
- un élément d'identification de position (16) qui est réalisée pour permettre d'identifier une position de l'élément de commutation (14) par rapport à la coulisse de commutation (11),
**caractérisé en ce que**
la coulisse de commutation (11) est réalisée conformément à l'une des revendications 1 à 6, les zones définies (I, II, III) de la surface de coulisse (13) de la coulisse de commutation (11) étant associées à la position neutre de l'élément de commutation (14) et à la ou aux position(s) de commutation de l'élément de commutation (14), et l'élément d'identification de position (16) permettant d'identifier la position respective de l'élément de commutation (14) étant réalisé pour déterminer l'intensité du champ magnétique dans les zones définies (I, II, III) de la surface de coulisse (13).

8. Dispositif de commutation conforme à la revendication 7, **caractérisé en ce que**
l'élément d'identification de position (16) comprend un capteur de champ magnétique permettant de déterminer l'intensité respective du champ magnétique.

9. Dispositif de commutation conforme à l'une des revendications 7 et 8,
selon lequel l'élément de commutation (14) est essentiellement réalisé de façon à pouvoir pivoter ou se déplacer par translation dans un plan par rapport à la coulisse de commutation (11) entre la position neutre et la ou les position(s) de commutation.

10. Dispositif de commutation conforme à l'une des revendications 7 à 9,
**caractérisé en ce que**
l'élément de commutation (14) comprend une tige de longueur variable permettant de palper la surface de coulisse (13) de la coulisse de commutation (11) tournée vers l'élément de commutation (14).

11. Dispositif de commutation conforme à l'une des revendications 7 à 10,
**caractérisé en ce que**
le dispositif de commutation (10) est un levier d'actionnement, en particulier un levier de commande de direction, un levier de commande de changement de vitesse électrique, un levier de commande de clignotant, un levier de commande d'essuie-glace ou un levier de commande de limiteur de vitesse.
